# EUROPEAN PATENT APPLICATION

(11) **EP 0 795 878 A2**
(43) Date of publication of application: **17.09.1997**
(21) Application number: 97104176.9
(22) Date of filing: 12.03.1997
(51) Int. Cl.: H01C 1/14, H01C 17/22

(54) **Chip resistor**

(30) Priority: 13.03.1996 JP 56466/96
(71) Applicant: Kamaya Electric Co., Ltd., Yamato-shi, Kanagawa-ken (JP)
(72) Inventor: Tohyama, Hideshi, Iwamizawa-shi, Hokkaido (JP)
(74) Representative: Herrmann-Trentepohl, Werner, Dipl.-Ing.

(57) **Abstract**

A chip resistor (10, 20, 30, 40, 50) is disclosed including an insulated substrate (11, 21, 31, 41, 51) having two opposed faces and two opposed ends, a resistor portion (12, 22, 32, 42, 52) formed on one of the two faces of the insulated substrate, a pair of electrode portions (13, 23, 33, 43, 53) each formed on one of the two opposed ends and both of the two faces of the insulated substrate, and coupled to opposite ends of the resistor portion, the chip resistor being adapted for mounting on a printed circuit board including a pair of lands and a protective coating therebetween with a raised portion, wherein each of the pair of electrode portions projects on both of the two faces of the insulated substrate so that the difference in height between the electrode portion and the other portions is larger than the difference in height between the land and the raised portion of the protective coating on both of the two faces.

## Description

This invention relates to a chip resistor, more specifically to a chip resistor which can ensure prevention of a tombstone phenomenon or defective soldering, and which can be mounted irrespective of the sides of the chip resistor.

### PRIOR ART

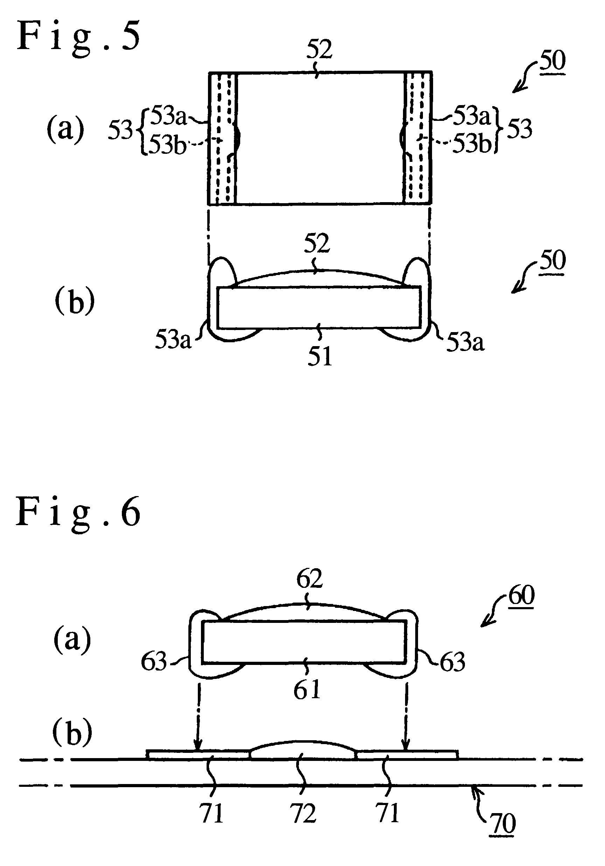

Conventionally, as shown in Fig. 6, a chip resistor 60 including an insulated substrate 61 provided with a resistor portion 62 (including a protective film or the like) and a pair of electrode portions 63, is mounted on a plurality of lands (conductive pattern) 71 disposed previously on a printed circuit board 70. Between the lands is provided a protective coating 72. When other conductive patterns (not shown) are disposed under the protective coating 72, a portion of the protective coating 72 may sometimes be raised on the printed circuit board 70, i.e. a portion of the protective coating 72 is projected between the lands 71.

As stated above, the conventional chip resistor 60 includes an insulated substrate 61 on which a resistor portion 62 and a pair of electrode portions 63 are provided. In general, on the upper face of the insulated substrate 61, the resistor portion 62 is provided projecting relative to the electrode portions 63, whereas on the lower face of the insulated substrate 61, the electrode portions 63 are projected relative to other portions than the electrode portions, i.e. the lower face of the insulated substrate 61, as shown in Fig. 6.

Therefore, with the conventional chip resistor 60, the electrode portions 63 are projected only on the lower face of the insulated substrate 61. Accordingly, when the chip resistor 60 is to be mounted on the printed circuit board 70 having the raised protective coating 72, the right side of the chip resistor 60 should be confirmed before it is mounted on the board 70 correctly. If the chip resistor 60 is mounted with the wrong side down, the raised resistor portion 62 of the chip resistor 60 is brought into contact with the raised protective coating 72 on the printed circuit board 70, so that the electrode portions 63 of the chip resistor 60 and the lands 71 on the board 70 are not intimately contacted, and gaps are created therebetween. These gaps may cause a tombstone phenomenon or defective soldering.

Recently, there has been a strong demand for a chip resistor which can be mounted conveniently irrespective of the sides of the chip resistors. However, such chip resistor enabling the mounting irrespective of the sides thereof has not yet proposed.

### SUMMARY OF THE INVENTION

The present invention is made to solve the above problems. Therefore, it is an object of the present invention to provide a chip resistor which can be mounted on a printed circuit board easily and accurately irrespective of the sides of the chip resistors, and which can prevent a tombstone phenomenon or defective soldering, without deteriorating the properties thereof such as soldering properties.

According to the present invention, there is provided a chip resistor comprising an insulated substrate having two opposed faces and two opposed ends, a resistor portion formed on one of said two faces of the insulated substrate, a pair of electrode portions each formed on one of said two opposed ends and both of said two faces of the insulated substrate, and coupled to opposite ends of the resistor portion, said chip resistor being adapted for mounting on a printed circuit board including a pair of lands and a protective coating therebetween with a raised portion, wherein each of said pair of electrode portions projects on both of said two faces of the insulated substrate so that a difference in height between the electrode portion and the other portions is larger than a difference in height between said land and said raised portion of said protective coating on both of said two faces.

According to the present invention, by projecting each of the electrode portions on both the upper and lower faces of the insulated substrate so that the difference in height between the electrode portion and the other portions is larger than the difference in height between the lands and the raised portion of the protective coating on both of the faces, the chip resistor of the present invention can be mounted on the printed circuit board easily and accurately irrespective of the sides of the chip resistor, and can prevent a tombstone phenomenon and defective soldering, without deteriorating the properties thereof such as soldering properties.

In the chip resistor of the present invention, the above mentioned resistor portion includes a trimmed resistive film and a protective film for protecting the resistive film, such as a glass overcoat or a resin overcoat, whereas the above mentioned electrode portion includes a basic electrode (primary top electrode), an end electrode (secondary top electrode) closely connected to the basic electrode, and a plated electrode film.

Projecting the electrode portion on both the upper and lower faces of the insulated substrate means to form the surface of the outermost layer of the electrode portion to be positioned at the most projected location from the surface of the insulated substrate relative to the other portions on the upper and lower faces of the substrate. Here, the other portions are the portions other than the electrode portion on one face of the insulated substrate. For example, in the case of a chip resistor having the resistor portion only on the upper face of the insulated substrate, the difference in height between the electrode portion and the other portions is, on the upper face of the insulated substrate, the difference in height between the highest point of the electrode portion and the outer most and the highest portion of the resistor portion, while on the lower face of the insulated substrate not provided with the resistor portion, the difference in height between the highest point of the electrode portion and the bottom surface of the insulated substrate.

Upon disposing the resistor portion on an insulated substrate having slits for facilitating later snapping of the substrate into each chip, the resistor portion may cover the entirety of the upper surface of the insulated substrate, bridging over the slits, or may cover the upper face of each section of the insulated substrate to the edge of the slits, before the electrode portion is disposed on the resistor portion. In this case, the basic electrode (primary top electrode) formed prior to and under the resistor portion may not entirely be covered by the resistor portion, i.e., the basic electrode (primary top electrode) may partially be exposed, on which the end electrode (secondary top electrode) and plated electrode film may be laminated, thereby ensuring the contact between the basic electrode and the end electrode and the like.

Each of the electrode portions may have a single or a plurality of projections on each face of the insulated substrate so that the chip resistor is mounted on the printed circuit board in a stable state without any shaking. For example, at least one electrode portion may be made to have two projections, while the other electrode portion may be made to have one projection, so that the chip resistor to be mounted on the printed circuit board is supported by at least three projections.

Alternatively, each of the electrode portions may be projected over the entire length of the end of the insulated substrate for achieving the stable mounting of the chip resistor on the printed circuit board.

### BRIEF DESCRIPTION OF THE DRAWINGS

In Fig. 1, (a) is a schematic plan view of an embodiment of the chip resistor of the present invention, and (b) is a schematic front view thereof.

In Fig. 2, (a) is a schematic plan view of another embodiment of the chip resistor of the present invention, and (b) is a schematic front view thereof.

In Fig. 3, (a) is a schematic plan view of yet another embodiment of the chip resistor of the present invention, and (b) is a schematic front view thereof.

In Fig. 4, (a) is a schematic plan view of yet another embodiment of the chip resistor of the present invention, and (b) is a schematic front view thereof.

In Fig. 5, (a) is a schematic plan view of yet another embodiment of the chip resistor of the present invention, and (b) is a schematic front view thereof.

In Fig. 6, (a) is a schematic front view of a conventional chip resistor, and (b) is a schematic cross sectional view of a printed circuit board on which the chip resistor in (a) is to be mounted.

### EXAMPLES

The present invention is explained with reference to Examples taken in conjunction with the attached drawings, but the present invention is not limited thereto.

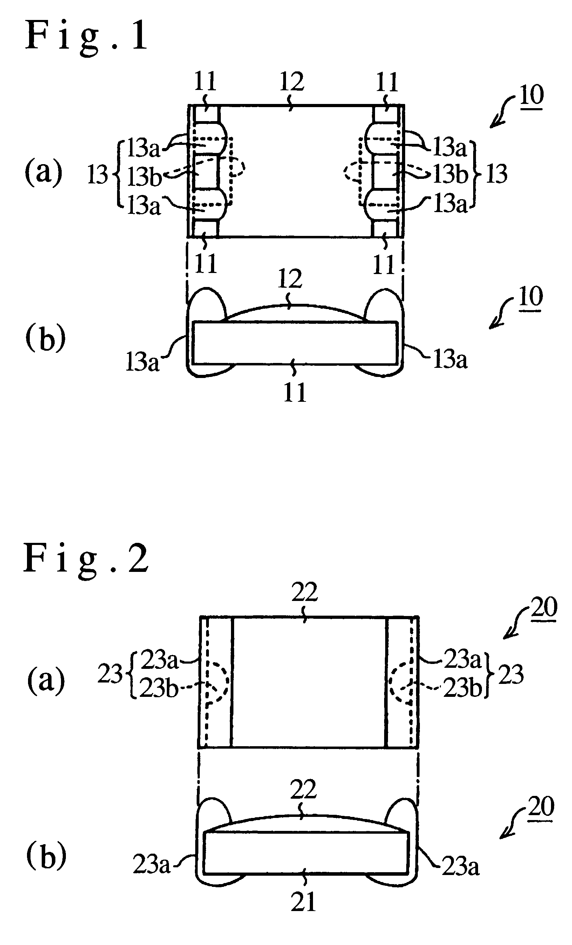

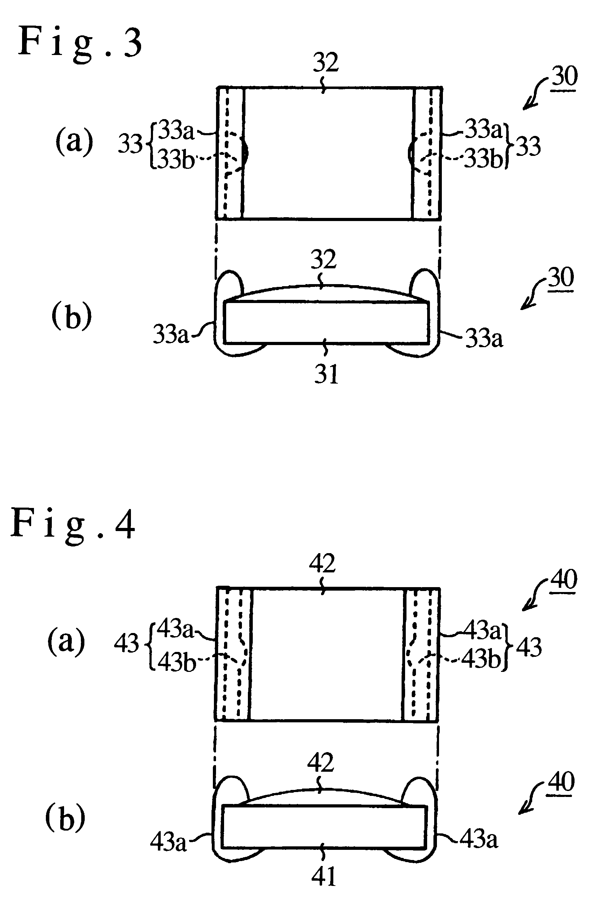

In Figs. 1 to 5, schematic plan views of various embodiments of the chip resistor of the present invention are indicated by (a), and schematic front views of these embodiments are indicated by (b).

Referring to Figs. 1(a) and (b), the chip resistor 10 of the present invention includes an insulated substrate 11, a resistor portion 12 formed on the upper surface of the insulated substrate 11, and a pair of electrode portions 13 each formed on one of the two opposed ends and both of upper and lower faces of the insulated substrate 11, and coupled to opposite ends of the resistor portion 12. The resistor portion 12 includes a trimmed resistive film and a protective film for protecting the resistive film such as a glass overcoat, a resin overcoat, or the like (not shown). Each of the electrode portion 13 includes a basic electrode (primary top electrode) 13b, an end electrode (secondary top electrode) in close contact with the basic electrode 13b, and a plated electrode film 13a. The electrode portion 13 is projected upwardly at two locations on each end of the upper face, and downwardly at two locations on each end of the lower face of the insulated substrate 11 so that the difference in height between the electrode portion 13 and the other portions is larger than the difference in height between the lands 71 on the printed circuit board 70 (Fig. 6) on which the chip resistor 10 is to be mounted and the raised portion of the protective coating 72 formed between the lands 71. Accordingly, the chip resistor is prevented from shaking upon mounting the same onto the printed circuit board (70 in Fig. 6), and can be mounted on the board stably and accurately.

Referring to Figs. 2 to 5, a chip resistor 20, 30, 40, 50 includes an insulated substrate 21, 31, 41, 51, a resistor portion 22, 32, 42, 52 formed on the upper face of the insulated substrate, and a pair of electrode portions 23, 33, 43, 53 each formed on one of the two opposed ends and both of upper and lower faces of the insulated substrate, and coupled to opposite ends of the resistor portion 22, 32, 42, 52. The resistor portion 22, 32, 42, 52 includes a trimmed resistive film and a protective film for protecting the resistive film such as a glass overcoat, a resin overcoat, or the like (not shown). Each of the electrode portion 23, 33, 43, 53 includes a basic electrode (primary top electrode) 23b, 33b, 43b, 53b, an end electrode (secondary top electrode) in close contact with the basic electrode, and a plated electrode film 23a, 33a, 43a, 53a. The electrode portion 23, 33, 43, 53 is projected upwardly on each end of the upper face, and downwardly on each end of the lower face of the insulated substrate 21, 31, 41, 51 so that the difference in height between the electrode portion 23, 33, 43, 53 and the other portions is larger than the difference in height between the lands 71 on the printed circuit board 70 (Fig. 6) on which the chip resistor 20, 30,40, 50 is to be mounted and the raised portion of the protective coating 72 formed between the lands 71.

In the chip resistor 20, 30, 40, 50, in order to increase the contact between the basic electrode 23b, 33b, 43b, 53b and the end electrode in the electrode portion 23, 33, 43, 53, the resistor portion 22, 32, 42, 52 is formed with notch portions at the opposed ends thereof so that a portion of the basic electrode is not covered with the resistor portion 22, 32, 42, 52 and is exposed to direct contact with the end electrode.

As stated above, in the chip resistor 10, 20, 30, 40, 50 of the present invention, The electrode portion 13, 23, 33, 43, 53 is projected upwardly on the upper face, and downwardly on the lower face of the insulated substrate 11, 21, 31, 41, 51 so that the difference in height between the electrode portion 13, 23, 33, 43, 53 and the other portions is larger than the difference in height between the lands on the printed circuit board on which the chip resistor 10, 20, 30,40, 50 is to be mounted and the raised portion of the protective coating formed between the lands. Therefore, the chip resistor of the present invention may be mounted on the printed circuit substrate easily and accurately irrespective of the sides of the chip resistor without deteriorating the properties such as soldering properties of the chip resistor, and a ombstone phenomenon and defective soldering can be prevented.

The resist or portion of the chip resistor may extend longitudinally between both ends of the chip resistor, but the present invention is not limited to this embodiment, and may be modified without departing from the scope of the present invention.

## Claims

1. A chip resistor (10, 20, 30, 40, 50) comprising:
an insulated substrate (11, 21, 31, 41, 51) having two opposed faces and two opposed ends,
a resistor portion (12, 22, 32, 42, 52) formed on one of said two faces of the insulated substrate,
a pair of electrode portions (13, 23, 33, 43, 53) each formed on one of said two opposed ends and both of said two faces of the insulated substrate, and coupled to opposite ends of the resistor portion,
said chip resistor being adapted for mounting on a printed circuit board including a pair of lands and a protective coating therebetween with a raised portion,
wherein each of said pair of electrode portions projects on both of said two faces of the insulated substrate so that a difference in height between the electrode portion and the other portions is larger than a difference in height between said land and said raised portion of said protective coating on both of said two faces.

2. The chip resistor as claimed in claim 1 wherein at least one of said pair of electrode portions (13) projects at a plurality of locations.

3. The chip resistor as claimed in claim 1 wherein each of said pair of electrode portions projects over an entire length of the end of the insulated substrate.

4. The chip resistor as claimed in any one of claims 1 to 3 wherein each of said pair of electrode portions (13, 23, 33, 43, 53) comprising a basic electrode (13b, 23b, 33b, 43b, 53b), an end electrode in close contact with the basic electrode, and a plated electrode film (13a, 23a, 33a, 43a, 53a), a portion of said basic electrode not being covered with the resistor portion to contact with the end electrode.
